# EUROPEAN PATENT SPECIFICATION

(11) **EP 3 749 796 B1**
(45) Date of publication and mention of the grant of the patent: **08.06.2022**
(21) Application number: 18703315.4
(22) Date of filing: 05.02.2018
(51) Int. Cl.: C23C 14/56, C23C 14/24, C23C 14/54

(54) **DEPOSITION APPARATUS FOR DEPOSITING EVAPORATED MATERIAL AND METHODS THEREFOR**
ABSCHEIDUNGSVORRICHTUNG ZUR ABSCHEIDUNG VON VERDAMPFTEM MATERIAL UND VERFAHREN DAFÜR
APPAREIL DE DÉPÔT PERMETTANT DE DÉPOSER UN MATÉRIAU ÉVAPORÉ ET PROCÉDÉS ASSOCIÉS

(43) Date of publication of application: 16.12.2020
(73) Proprietor: Applied Materials, Inc., Santa Clara, California 95054 (US)
(72) Inventor: DEPPISCH, Thomas, 63743 Aschaffenburg (DE); ARMSTRONG, Claire, 51643 Gummersbach (DE); SCHNAPPENBERGER, Frank, 63867 Johannesberg (DE)
(74) Representative: Zimmermann & Partner Patentanwälte mbB
(86) International application number: PCT/EP2018/052798
(87) International publication number: WO 2019/149382

(56) References cited:
- WO-A1-2016/202388
- JP-A- H0 665 722
- JP-A- S6 164 880
- JP-A- H08 287 459
- JP-A- 2004 061 810
- JP-A- 2012 126 938
- US-A1- 2007 246 356
- US-B1- 6 337 105
- US-B1- 6 475 354
- US-B1- 8 030 725
- Emmanuel S Thibau: "Photoemission Spectroscopy Studies of Methylammonium Lead Iodide Perovskite Thin Films and Interfaces", , 1 June 2016 (2016-06-01), XP055534419, ISBN: 978-1-339-88693-0 Retrieved from the Internet: URL:https://tspace.library.utoronto.ca/bit stream/1807/72812/1/Thibau_Emmanuel_S_2016 06_MAS_thesis.pdf [retrieved on 2018-12-14]

## Description

### TECHNICAL FIELD

Embodiments of the disclosure relate to deposition apparatuses for depositing one or more layers on a substrate, particularly a flexible substrate. In particular, embodiments of the present disclosure relate to apparatuses for coating a substrate with one or more layers, e.g. for thin-film solar cell production, flexible display production or thin-film battery production. More particularly, embodiments of the present disclosure relate to apparatuses and methods for coating a flexible substrate in a roll-to-roll (R2R) process. Specifically, embodiments of the present disclosure relate to a deposition apparatus having a device for measuring a deposition rate of an evaporated material to be deposited. Further, embodiments of the present disclosure relate to methods of using a deposition rate measurement device, particularly for preparing a deposition apparatus for a deposition process as well as for measuring a deposition rate during material deposition.

### BACKGROUND

Depositing thin layers on a flexible substrate is a production process for many applications. The flexible substrates are coated in one or more chambers of a flexible substrate coating apparatus. The flexible substrates, such as foils made of plastics or pre-coated papers, are guided on rolls or drums and pass in this way the source of deposition material. Possible applications of the coated substrate range from providing coated foils for the packaging industry to depositing thin films for flexible electronics and advanced technology applications, such as smartphones, flat screen TVs and solar panels.

Different deposition processes may be used to achieve a layer with the desired properties. For instance, in a thermal evaporation deposition process, evaporated material is deposited onto a substrate, e.g. a flexible substrate, for providing a coating on the substrate. The properties and the functionality of the coating, inter alia, depend on the coating thickness. Accordingly, there is a demand to control the coating thickness to be within a predetermined range. For instance, the coating thickness can be adjusted by adjusting a deposition rate of the material to be deposited on the substrate.

With respect to the prior art exemplary reference is made to document US 8 030 725 B1. US 8 030 725 B1 relates to an apparatus and methods for detecting evaporation conditions in an evaporator for evaporating metal onto semiconductor wafers, such as GaAs wafers. The apparatus of US 8 030 725 B1 can include a crystal monitor sensor configured to detect metal vapor associated with a metal source prior to metal deposition onto a semiconductor wafer. The apparatus of US 8 030 725 B1 can also include a shutter configured to remain in a closed position when the crystal monitor sensor detects an undesired condition, so as to prevent metal deposition onto the semiconductor wafer. In some implementations, the undesired condition can be indicative of a composition of a metal source, a deposition rate of a metal source, impurities of a metal source, position of a metal source, position of an electron beam, and/or intensity of an electron beam.

Accordingly, there is a continuing demand for providing deposition apparatuses with which the deposition rate can be adjusted with a high accuracy and which can be maintained a comparably long time.

In view of the above, a deposition apparatus and methods therefor are provided which are improved compared to conventional deposition systems and methods therefor.

### SUMMARY

In light of the above, a deposition apparatus for depositing evaporated material onto a substrate, a method of preparing a deposition apparatus for depositing evaporated material on a substrate, and a method of measuring a deposition rate of evaporated material are provided. Further aspects, advantages, and features are apparent from the dependent claims, the description, and the accompanying drawings. The invention is defined in the appended claims.

According to an aspect of the present disclosure, a deposition apparatus for depositing evaporated material onto a substrate is provided. The deposition apparatus includes a deposition source for providing evaporated material, a material deposition zone provided between the deposition source and the substrate, a deposition rate measurement device provided in the material deposition zone, and a movable shutter provided in the material deposition zone. The movable shutter is configured to be moved in a first position, a second position and a third position. The first position is a position in which evaporated material is blocked from being deposited on the substrate as well as blocked from being deposited on the deposition rate measurement device. The second position is a position in which evaporated material is blocked from being deposited on the substrate and allowed to be deposited on the deposition rate measurement device. The third position is a position in which evaporated material is allowed to be deposited on the substrate as well as allowed to be deposited on the deposition rate measurement device.

According to a further aspect of the present disclosure, a roll-to-roll deposition apparatus for depositing evaporated material onto a flexible substrate is provided. The roll-to-roll deposition apparatus includes a deposition source for providing evaporated material. The deposition source has an evaporation crucible being configured to evaporate the material to be deposited. Additionally, the roll-to-roll deposition apparatus includes a material deposition zone provided between the deposition source and the flexible substrate. The material deposition zone has a conus-like shape with an opening angle α of 45° ≤ α ≤ 90° with respect to a main deposition direction of the deposition source. Further, the roll-to-roll deposition apparatus includes a movable shutter provided in the material deposition zone. The movable shutter is configured to be moved in a first position, a second position and a third position. The first position is a position in which evaporated material is blocked from being deposited on the substrate as well as blocked from being deposited on the deposition rate measurement device. The second position is a position in which evaporated material is blocked from being deposited on the substrate and allowed to be deposited on the deposition rate measurement device. The third position is a position in which evaporated material is allowed to be deposited on the substrate as well as allowed to be deposited on the deposition rate measurement device. Further, the roll-to-roll deposition apparatus includes a deposition rate measurement device provided in an edge region of the material deposition zone.

According to another aspect of the present disclosure, a method of preparing a deposition apparatus for depositing evaporated material on a substrate is provided. The method includes evaporating a material to be deposited using a deposition source, blocking the evaporated material from being deposited onto the substrate by employing a movable shutter provided in a material deposition zone provided between the deposition source and the substrate, and measuring a deposition rate by a deposition rate measurement device provided in the material deposition zone, particularly between the deposition source and the shutter.

The movable shutter is configured to be moved in a first position, a second position and a third position. The first position is a position in which evaporated material is blocked from being deposited on the substrate as well as blocked from being deposited on the deposition rate measurement device. The second position is a position in which evaporated material is blocked from being deposited on the substrate and allowed to be deposited on the deposition rate measurement device. The third position is a position in which evaporated material is allowed to be deposited on the substrate as well as allowed to be deposited on the deposition rate measurement device.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
FIG. 1A shows a schematic view of a deposition apparatus according to embodiments described herein, wherein a movable shutter is shown in a blocking position for preventing evaporated material from being deposited onto the substrate;
FIG. 1B shows a schematic view of a deposition apparatus according to embodiments described herein, wherein the movable shutter is shown in a non-blocking position allowing evaporated material to be deposited onto the substrate;
FIG. 2 shows a schematic view of a deposition apparatus according to further embodiments described herein;
FIG. 3A shows a schematic view of a deposition apparatus according to embodiments described herein, wherein a further movable shutter is shown in a blocking position for preventing evaporated material from being deposited onto a deposition rate measurement device;
FIG. 3B shows a schematic view of a deposition apparatus according to embodiments described herein, wherein the further movable shutter is shown in a non-blocking position allowing evaporated material to be detected by the deposition rate measurement device;
FIG. 4A shows a schematic view of a deposition apparatus according to further other embodiments described herein;
FIGS. 4B to 4D show a schematic view of a deposition apparatus according to further embodiments described herein, wherein the movable shutter is shown in a first position T1 (FIG. 4B), a second position T2 (FIG. 4C) and a third position T3 (FIG. 4D);
FIG. 5 shows a schematic view of a deposition apparatus according to embodiments described herein, the deposition apparatus being a roll-to-roll deposition apparatus;
FIGS. 6A and 6B show flowcharts for illustrating a method of preparing a deposition apparatus for depositing evaporated material on a substrate according to embodiments described herein; and
FIG. 7 shows a flowchart for illustrating a method of measuring a deposition rate of evaporated material according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

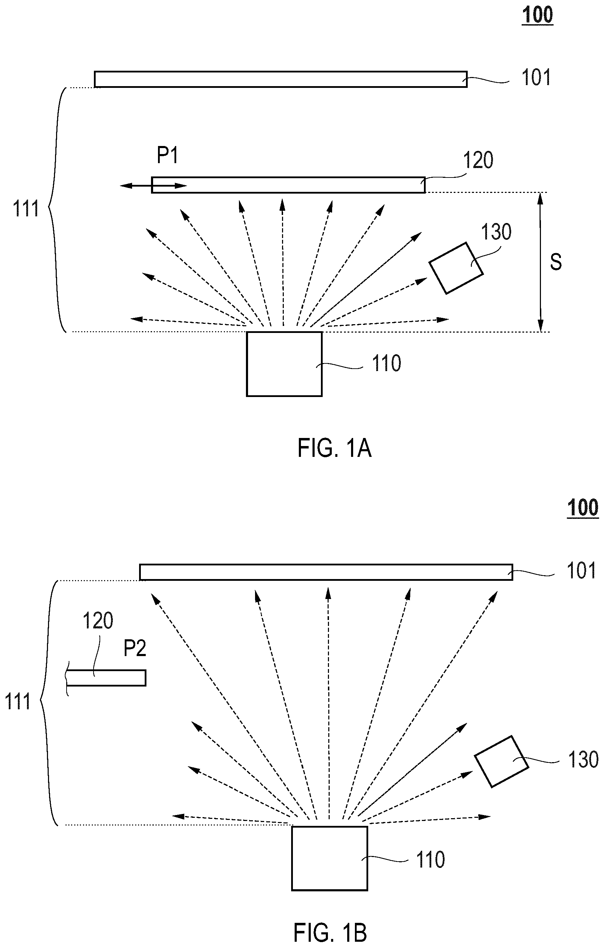

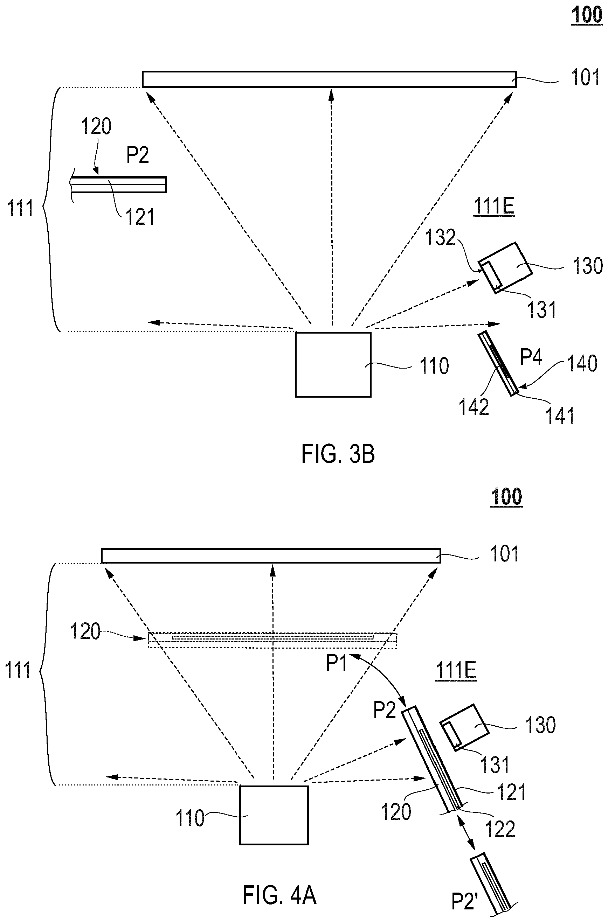

With exemplary reference to FIGS. 1A to 4D, a deposition apparatus 100 for depositing evaporated material onto a substrate 101 according to the present disclosure is described herein. According to embodiments which can be combined with any other embodiments described herein, the deposition apparatus 100 includes a deposition source 110 for providing evaporated material. Further, the deposition apparatus 100 includes a material deposition zone 111 provided between the deposition source 110 and the substrate 101. Additionally, a movable shutter 120 is provided in the material deposition zone 111. As exemplarily shown in FIGS. 1A and 1B, the deposition apparatus 100 includes a deposition rate measurement device 130 provided in the material deposition zone 111. In particular, the deposition rate measurement device 130 is provided between the deposition source 110 and the movable shutter 120. More specifically, the deposition rate measurement device 130 is arranged in a space S of the material deposition zone 111, which is delimited by the deposition source on the one side and a plane defined by a surface of the movable shutter in a blocking position on the other side, as exemplarily shown in FIG. 1A.

FIG. 1A shows a schematic view of a deposition apparatus 100 according to embodiments described herein, wherein the movable shutter 120 is in a blocking position for preventing evaporated material from being deposited onto the substrate 101. FIG. 1B shows a schematic view of the deposition apparatus, wherein the movable shutter 120 is in a non-blocking position allowing evaporated material to be deposited onto the substrate 101.

Accordingly, embodiments of the deposition apparatus as described herein are improved compared to conventional deposition apparatus. In particular, embodiments of the present disclosure beneficially provide for the possibility to adjust and control a deposition rate prior to material deposition on the substrate. For instance, beneficially the deposition apparatus as described herein is configured such that when a preselected deposition rate of evaporated material has been achieved, the substrate to be coated is exposed to the evaporated material by moving the movable shutter from a blocking position (see, e.g., FIG. 1A) to a non-blocking position (see, e.g., FIG. 1B). Accordingly, the deposition rate measurement device can be employed for adjusting the deposition rate to a preselected target deposition rate as well as for controlling the target deposition rate during material deposition.

Before various further embodiments of the present disclosure are described in more detail, some aspects with respect to some terms used herein are explained.

In the present disclosure, the term "substrate" may embrace flexible substrates such as a web or a foil. However, the present disclosure is not limited thereto, and the term "substrate" may also embrace substantially inflexible substrates, e.g., a wafer, slices of transparent crystal such as sapphire or the like, or a glass plate. The term "substantially inflexible" is understood to be distinguished over "flexible". Specifically, a substantially inflexible substrate can have a certain degree of flexibility, e.g. a glass plate having a thickness of 0.5 mm or below, wherein the flexibility of the substantially inflexible substrate is small in comparison to the flexible substrates.

According to embodiments described herein, the substrate may be made of any material suitable for material deposition. For instance, the substrate may be made of a material selected from the group consisting of glass (for instance sodalime glass, borosilicate glass etc.), metal, polymer, ceramic, compound materials, carbon fiber materials or any other material or combination of materials which can be coated by a deposition process. In particular, a "flexible substrate" may be understood as a substrate that is bendable. In particular, a flexible substrate as referred to herein may be understood as a substrate suitable for being coated in an evaporation apparatus, in particular in a reactive evaporation apparatus. For example, the flexible substrate may be a foil or a web, e.g. foil or a web made of or containing plastics and polymers (such as polypropylene, PET substrates, substrates made of or containing OPP, BOPP, CPP, PE, LDPE, HDPE, OPA, PET), pre-coated paper, or biodegradable films (such as PLA).

In the present disclosure, a "deposition source" can be an evaporation source for evaporation of material. Accordingly, a deposition source as described herein can be understood as a device or assembly configured for providing evaporated material to be deposited on a substrate. In particular, a deposition source as described herein typically includes a crucible having a reservoir for the material to be evaporated by heating the crucible. The reservoir can have an inner volume for receiving the source material to be evaporated, e.g. an organic material. For example, the inner volume of the crucible can be between 100 cm³ and 3000 cm³, particularly between 700 cm³ and 1700 cm³, more particularly 1200 cm³.

For instance, the material to be evaporated may be a material having an evaporation temperature of about 100°C to about 600°C. In particular, the material to be evaporated can be an organic material, for instance for organic light emitting diode (OLED) production. For instance, initially the material to be evaporated can be in the form of a powder. According to another configuration, a crucible as described herein may be equipped with a material supply for delivering the material to be evaporated to the crucibles. For example, the material to be evaporated may be supplied to the evaporation crucible in the form of a wire which may be melted by the crucible.

Accordingly, a crucible can be understood as a material reservoir which can be heated to vaporize the material into a gas by at least one of evaporation and sublimation of the material contained in the crucible. In particular, a crucible as described herein may be configured for heating the material delivered to the crucibles to the melting temperature and further to the evaporation temperature of the respective material to be evaporated.

In the present disclosure, a "material deposition zone" can be understood as the zone or space between the deposition source and the substrate to be coated. In particular, the material deposition zone is the zone or space in which during operation of the deposition source evaporated material is provided.

In the present disclosure, a "movable shutter" may be understood as a movable element which can be arranged between the deposition source and the substrate to be coated, such that evaporated material originating from the deposition source is prevented from being deposited on the substrate. Further, the movable shutter can be configured to be arranged between the deposition source and the deposition rate measurement device such that evaporated material originating from the deposition source is prevented from being deposited on the deposition rate measurement device. In particular, a "movable shutter" may be understood as an element which is configured to be moved in the material deposition zone as described herein. Accordingly, a movable shutter can be configured for controlling an access of evaporated material to the substrate and/or deposition rate measurement device as described herein.

In the present disclosure, a "deposition rate measurement device" can be understood as a device configured for measuring a deposition rate of evaporated material. For instance, the deposition rate measurement device can be a mechanical measurement device, e.g. having a quartz crystal resonator, or an optical measurement device, e.g. having a camera.

As can be seen from FIGS. 1A and 1B, according to embodiments which can be combined with other embodiments described herein, the movable shutter 120 is movable between a blocking position and a non-blocking position. The dotted arrows in FIGS. 1A and 1B symbolize evaporated material originating from the deposition source 110. In particular, the blocking position is a first position P1 (see FIG. 1A) preventing evaporated material from being deposited onto the substrate and the non-blocking position is a second position P2 (see FIG. 1B) allowing evaporated material to be deposited onto the substrate. As shown in FIGS. 1A and 1B, irrespective of whether the movable shutter 120 is in the first position P1 or the second position P2, the deposition rate measurement device 130 is arranged such that a deposition rate of evaporated material originating from the deposition source 110 can be measured by the deposition rate measurement device 130.

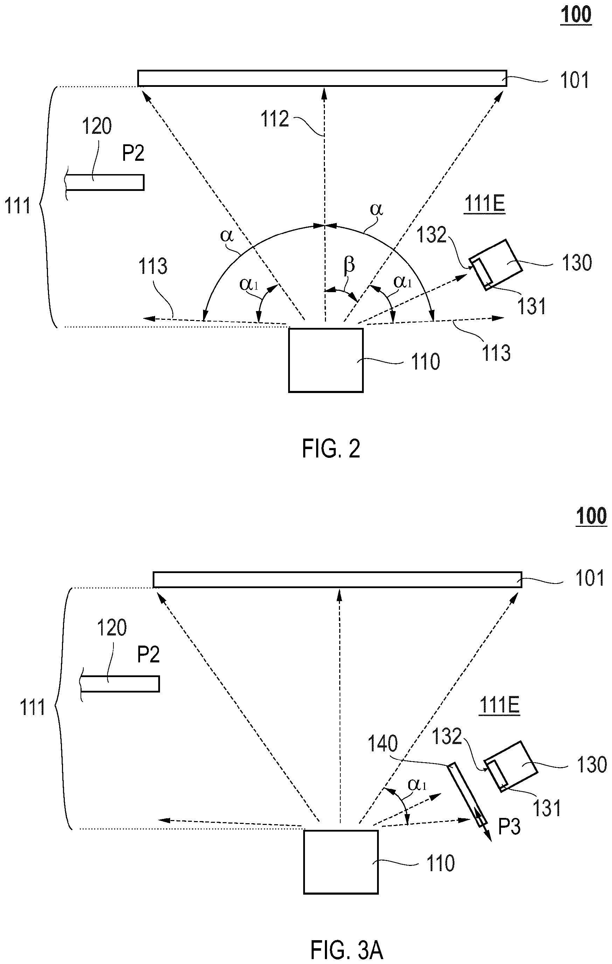

With exemplary reference to FIG. 2, according to embodiments which can be combined with other embodiments described herein, the deposition rate measurement device 130 is arranged in an edge region 111E of the material deposition zone 111. In the present disclosure, an "edge region of the material deposition zone" can be understood as the region or space of the material deposition zone in which evaporated material originating from the deposition source does not hit the substrate. Accordingly, the arrangement of the deposition rate measurement device 130 in the edge region 111E of the material deposition zone 111 does not prevent evaporated material from being deposited on the substrate 101.

As exemplarily shown in FIG. 2, according to embodiments which can be combined with other embodiments described herein, the deposition source 110 has a main deposition direction 112. In particular, the main deposition direction 112 can be understood as the direction of evaporated material which originates perpendicularly from the deposition source. More specifically, the main deposition direction 112 may be the direction of evaporated material which originates perpendicularly from the deposition source and also hits the substrate perpendicularly.

Typically, the material deposition zone 111 can have a conus-like shape with an opening angle α of 45° ≤ α < 90° with respect to a main deposition direction 112 of the deposition source, as exemplarily illustrated in FIG. 2. Accordingly, the opening angle α can be understood as the angle between the main deposition direction 112 (α =0°) and the edge 113 of the material deposition zone 111. The edge region 111E of the material deposition zone 111 is a region provided around the main deposition direction 112 from the opening angle α to a first angle α1 being smaller than the opening angle α. Accordingly, the edge region 111E of the material deposition zone 111 can be understood as the region delimited by edge 113 of the material deposition zone 111 and a material deposition direction originating from the deposition source 110 with an angle β of β = α- α₁ with respect to the main deposition direction 112. In particular, the first angle α₁ has a value selected from the range of 0.5 × α ≤ α₁ ≤ α.

As schematically shown in FIG. 2, according to some embodiments which can be combined with other embodiments described herein, the deposition rate measurement device 130 includes an oscillation crystal 131 for measuring a deposition rate. An "oscillation crystal" may be understood as an oscillation crystal which is configured for measuring a mass variation of deposited material on the oscillation crystal per unit area by measuring the change in frequency of an oscillation crystal resonator. In particular, in the present disclosure an oscillation crystal may be understood as a quartz crystal resonator. Accordingly, an oscillation crystal as described is configured for measuring the deposition rate and can be a quartz crystal microbalance (QCM).

With exemplary reference to FIG. 2, according to some embodiments which can be combined with other embodiments described herein, the deposition rate measurement device 130 is arranged such that a detection surface 132 of the oscillation crystal 131 is oriented to be perpendicular to an evaporation direction of the deposition source, which can be beneficial for high accuracy measurements. The term "evaporation direction" can be understood as a direction of a stream of evaporated material originating from the deposition source.

With exemplary reference to FIGS. 3A and 3B, according to some embodiments which can be combined with other embodiments described herein, deposition apparatus 100 can include a further movable shutter 140 provided in the material deposition zone 111 between the deposition source 110 and the deposition rate measurement device 130. Accordingly, the "further movable shutter" as described herein can be understood as a movable element which can be arranged between the deposition rate measurement device and the deposition source. Typically, the movable shutter is configured for preventing evaporated material originating from the deposition source from being detected by the deposition rate measurement device. Accordingly, the further movable shutter is configured for controlling an access of evaporated material to the deposition rate measurement device.

As can be seen from FIG. 3A and 3B, according to embodiments which can be combined with other embodiments described herein, the further movable shutter 140 is movable between a further blocking position P3 and a further non-blocking position P4. In particular, the further blocking position P3 is a position in which evaporated material is prevented from being deposited onto the deposition rate measurement device 130. The further non-blocking position P4 is a position allowing evaporated material to be detected by the deposition rate measurement device 130.

With exemplary reference to FIG. 3B, according to some embodiments which can be combined with other embodiments described herein, the movable shutter 120 may include a thermal protection shield 121. Additionally or alternatively, the movable shutter 120 can include a thermal element 122. In particular, the thermal element 122 can be a cooling element for actively cooling the movable shutter 120.

Accordingly, in a blocking position of the movable shutter 120, i.e. the first position P1, beneficially the substrate can be protected from heat exposure resulting from the evaporated material. In particular, the thermal protection shield 121 may be configured for reflecting heat energy provided by evaporated material provided from the deposition source 110. For instance, the thermal protection shield 121 may be a plate, for example a sheet metal. Alternatively, the thermal protection shield 121 may include two or more plates, particularly two of more metal sheets, which may be spaced with respect to each other, for example by a gap of 0.1 mm or more. For example, the sheet metal may have a thickness of 0.1 mm to 3.0 mm. In particular, the thermal protection shield may include a ferrous or non-ferrous material, for example at least one material selected from the group consisting of copper (Cu), aluminum (Al), copper alloy, aluminum alloy, brass, iron, titanium (Ti), ceramic and other suitable materials.

With exemplary reference to FIG. 3B, according to some embodiments which can be combined with other embodiments described herein, the further movable shutter 140 may include a further thermal protection shield 141. Additionally or alternatively, the further movable shutter 140 can include a further thermal element 142. In particular, the further thermal element 142 can be a cooling element for actively cooling the further movable shutter 140.

Accordingly, in a blocking position of the further movable shutter 140, i.e. the further blocking position P3, beneficially the deposition rate measurement device 130 can be protected from heat exposure resulting from the evaporated material. Further, it is to be understood that the further thermal protection shield 141 can be configured in the same way as the thermal protection shield 121, e.g. including two or more plates as described for the thermal protection shield 121.

According to some embodiments which can be combined with other embodiments described herein, the further thermal element 142 can be configured for applying heat to the deposition rate measurement device, particularly the oscillation crystal 131. Accordingly, beneficially the oscillation crystal 131 can be cleaned by heating, particularly by providing a heating temperature which corresponds to the evaporation temperature of evaporated material deposited on the oscillation crystal 131.

As exemplarily shown in FIG. 4A, according to some embodiments which can be combined with other embodiments described herein, the second position P2 of the movable shutter 120 allowing evaporated material to be deposited onto the substrate can be a position in which evaporated material is prevented by the shutter from being deposited onto the deposition rate measurement device 130. Accordingly, beneficially the movable shutter 120 may have a dual function, i.e. blocking and unblocking the substrate as well as blocking and unblocking the deposition rate measurement device.

According to some embodiments which can be combined with other embodiments described herein, the thermal element 122 of the movable shutter 120 can be configured for applying heat. Providing the movable shutter 120 with a thermal element configured for applying heat can be beneficial for a configuration in which the movable shutter fulfills a dual function as exemplarily shown in FIG. 4A. In particular, the thermal element 122 of the movable shutter 120 can be employed for cleaning the oscillation crystal 131 in a similar way as described for the further thermal element 142 of the further movable shutter 140.

With exemplary reference to FIG. 4A, according to some embodiments which can be combined with other embodiments described herein, the movable shutter 120 may be movable from a second position P2, in which evaporated material is prevented by the movable shutter 120 from being deposited onto the deposition rate measurement device 130, to a third position P2'. As exemplarily shown in FIG. 4A, typically the third position P2' is a position of the movable shutter 120 in which evaporated material can be deposited on the substrate 101 and can be detected by the deposition rate measurement device 130.

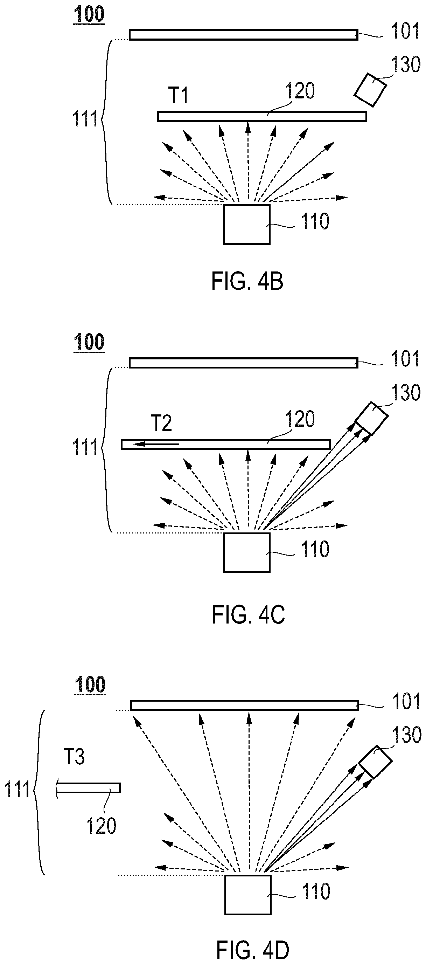

With exemplary reference to FIGS. 4B to 4D, an embodiment of the deposition apparatus for depositing evaporated material onto a substrate is described which can be combined with other embodiments described herein. As shown in FIGS. 4B to 4D, the deposition apparatus 100 includes a deposition source 110 for providing evaporated material; a material deposition zone 111 provided between the deposition source 110 and the substrate 101; a deposition rate measurement device 130 provided in the material deposition zone 111; and a movable shutter 120 provided in the material deposition zone 111. The movable shutter is configured to be moved in a first position T1, a second position T2 and a third position T3. As shown in FIG. 4B, the first position T1 is a position in which evaporated material is blocked from being deposited on the substrate 101 as well as blocked from being deposited on the deposition rate measurement device 130. As shown in FIG. 4C, the second position T2 is a position in which evaporated material is blocked from being deposited on the substrate 101 and allowed to be deposited on the deposition rate measurement device 130. As shown in FIG. 4D, the third position T3 is a position in which evaporated material is allowed to be deposited on the substrate 101 as well as allowed to be deposited on the deposition rate measurement device 130. Accordingly, it is to be understood that the movable shutter 120 can be configured to be moved to three different positions (i.e. a first position T1, a second position T2, and a third position T3), such that three different states of the movable shutter can be provided, as exemplarily shown in FIGS. 4B to 4D. Accordingly, a deposition apparatus is provided in which a single shutter provides for blocking and unblocking a substrate as well as for blocking and unblocking a deposition rate measurement device.

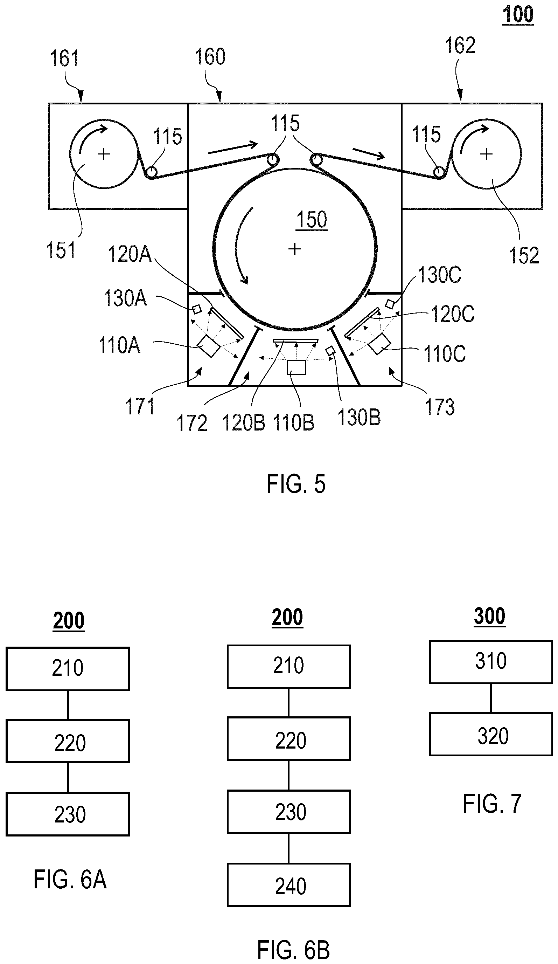

According to some embodiments which can be combined with other embodiments described herein, the deposition apparatus 100 is a roll-to-roll deposition apparatus, as schematically shown in FIG. 5. Accordingly, the substrate can be a flexible substrate. Further, the deposition apparatus may have at least one roll configured for transporting the flexible substrate. For instance, the at least one roll configured for transporting the flexible substrate may be a processing drum 150 as exemplarily shown in FIG. 5. Accordingly, a "processing drum" is to be understood as a roll or roller which is used during processing, e.g. coating, of a flexible substrate as described herein. In particular, a "processing drum" is to be understood as a roller which is configured to support a flexible substrate during processing. More specifically, the processing drum as described herein may be arranged and configured such that the flexible substrate, e.g. a foil or a web, is wound around at least a part of the processing drum. For instance, during processing, typically the flexible substrate is in contact with at least a lower portion of the processing drum.

Further, as exemplarily shown in FIG. 5, typically the deposition apparatus 100 includes a vacuum deposition chamber 160. In particular, a "vacuum deposition chamber" is to be understood as a chamber configured for vacuum deposition. The term "vacuum", as used herein, can be understood in the sense of a technical vacuum having a vacuum pressure of less than, for example, 10 mbar. Typically, the pressure in a vacuum chamber as described herein may be between 10⁻⁵ mbar and about 10⁻⁸ mbar, more typically between 10⁻⁵ mbar and 10⁻⁷ mbar, and even more typically between about 10⁻⁶ mbar and about 10⁻⁷ mbar. According to some embodiments, the pressure in the vacuum chamber may be considered to be either the partial pressure of the evaporated material within the vacuum chamber or the total pressure (which may approximately be the same when only the evaporated material is present as a component to be deposited in the vacuum chamber). In some embodiments, the total pressure in the vacuum chamber may range from about 10⁻⁴ mbar to about 10⁻⁷ mbar, especially in the case that a second component besides the evaporated material is present in the vacuum chamber (such as a gas or the like).

With exemplarily reference to FIG. 5, according to some embodiments which can be combined with other embodiments described herein, the deposition apparatus 100 may include a first spool chamber 161, the vacuum deposition chamber 160 arranged downstream from the first spool chamber 161, and a second spool chamber 162 arranged downstream from the vacuum deposition chamber 160. The first spool chamber 161 typically houses a storage spool 151 with a flexible substrate wound thereon, and the second spool chamber 162 typically houses a wind-up spool 152 for winding the coated flexible substrate thereon after deposition. Further, a roller assembly 115 comprising a plurality of rolls or rollers can be provided for transporting the substrate along a substrate transportation path from the storage spool 151 through the vacuum deposition chamber 160 to the wind-up spool 152.

The term "downstream from" as used herein may refer to the position of the respective chamber or of the respective component with respect to another chamber or component along the substrate transportation path. For example, during operation, the substrate is guided from the first spool chamber 161 through the vacuum deposition chamber 160 and subsequently guided to the second spool chamber 162 along the substrate transportation path via the roller assembly 115. Accordingly, the vacuum deposition chamber 160 is arranged downstream from the first spool chamber 161, and the second spool chamber 162 is arranged downstream from the vacuum deposition chamber 160.

According to some embodiments which can be combined with other embodiments described herein, the deposition apparatus can include two or more compartments, each compartment having a deposition source as described herein, a deposition rate measurement device, and a movable shutter as described herein. Further, each compartment of the two or more compartments may include a further movable shutter as described herein. For illustration purposes, FIG. 5 shows an embodiment having three compartments, namely a first compartment 171, a second compartment 172 and a third compartment 173. The first compartment 171 includes a first deposition source 110A, a first movable shutter 120A and a first deposition rate measurement device 130A. The second compartment 172 includes a second deposition source 110B, a second movable shutter 120B and a second deposition rate measurement device 130B. The third compartment 173 includes a third deposition source 110C, a third movable shutter 120C and a third deposition rate measurement device 130C.

Accordingly, according to an exemplary embodiment which can be combined with other embodiments described herein, a roll-to-roll deposition apparatus for depositing evaporated material onto a flexible substrate is provided. In particular, the roll-to-roll deposition apparatus may include a deposition source for providing evaporated material, e.g. a first deposition source 110A, a second deposition source 110B and/or a third deposition source 110C. Typically, the deposition source includes an evaporation crucible being configured to evaporate the material to be deposited. Further, typically a material deposition zone is provided between the deposition source and the flexible substrate. For instance, as described with reference to FIG. 2, the material deposition zone can have a conus-like shape with an opening angle α of 45° ≤ α ≤ 90° with respect to a main deposition direction of the deposition source. Further, the roll-to-roll deposition apparatus typically includes a movable shutter provided in the material deposition zone, e.g. a first movable shutter 120A, a second movable shutter 120B, and/or a third movable shutter 120C.

As described herein, the movable shutter is configured to be movable between a first position P1 and a second position P2. The first position P1 is a position of the shutter preventing evaporated material from being deposited onto the flexible substrate and the second position P is a position of the shutter allowing evaporated material to be deposited onto the flexible substrate. Further, the roll-to-roll deposition apparatus includes a deposition rate measurement device, e.g. a first deposition rate measurement device 130A, a second deposition rate measurement device 130B, and/or a third deposition rate measurement device 130C. Typically, the deposition rate measurement device is provided in an edge region 111E of the material deposition zone between the deposition source and the shutter when the shutter is in the first position. As exemplarily described with reference to FIG. 2, the edge region of the material deposition zone is a region provided around the main deposition direction from the opening angle α to a first angle α1 with respect to the main deposition direction 112. In particular, the first angle α1 has a value selected from the range of 0.5 × α ≤ α1 ≤ α.

With exemplary reference to the flowcharts shown in FIGS. 6A and 6B, a method 200 of preparing a deposition apparatus for depositing evaporated material on a substrate 101 according to the present disclosure is described. The method 200 includes evaporating (block 210) a material to be deposited using a deposition source 110, particularly a deposition source as described herein. Additionally, the method includes preventing (block 220) the evaporated material from being deposited onto the substrate 101 by employing a movable shutter 120, particularly a movable shutter as described herein. Typically, the movable shutter is provided in a material deposition zone 111 provided between the deposition source 110 and the substrate 101, as exemplarily described with reference to FIGS. 1A and 1B. Further, the method 200 includes measuring (block 230) a deposition rate by a deposition rate measurement device 130 provided in the material deposition zone 111 between the deposition source 110 and the movable shutter 120. Typically, the deposition rate measurement device 130 is a deposition rate measurement device as described herein.

As exemplarily shown in FIG. 6B, according to some embodiments which can be combined with other embodiments described herein, the method 200 further includes moving (block 240) the movable shutter 120 for unblocking the substrate when a preselected deposition rate has been measured by the deposition rate measurement device 130.

Accordingly, beneficially a method is provided with which a deposition rate prior to material deposition on the substrate can be adjusted and controlled such that when a preselected deposition rate of evaporated material has been achieved, the substrate to be coated can be exposed to the evaporated material by moving the movable shutter from a blocking position (see, e.g., FIG. 1A) to a non-blocking position (see, e.g., FIG. 1B).

With exemplary reference to the flowchart shown in FIG. 7, a method 300 of measuring a deposition rate of evaporated material according to the present disclosure is described. The method 300 includes depositing (block 310) evaporated material on a substrate 101 using a deposition source 110, particularly a deposition source as described herein. Further, the method 300 includes measuring (block 320) a deposition rate by a deposition rate measurement device 130, particularly a deposition rate measurement device as described herein. Typically, the deposition rate measurement device 130 is provided in an edge region 111E of a material deposition zone 111, as exemplarily described with reference to FIG. 2. In particular, the material deposition zone can have a conus-like shape with an opening angle α of 45° ≤ α ≤ 90° with respect to a main deposition direction 112 of the deposition source 110, e.g. as described with reference to FIG. 2. In particular, the edge region 111E can be a region provided around the main deposition direction 112 from the opening angle α to a first angle α1 with respect to the main deposition direction 112. Typically, the first angle α1 has a value selected from the range of 0.5 × α ≤ α1 ≤ α.

In view of the embodiments described herein, it is to be understood that the embodiments of the deposition apparatus and the embodiments of the methods therefor are improved with respect to the state of the art. In particular, embodiments of the present disclosure provide for the possibility to adjust and control a deposition rate prior to material deposition on the substrate. When a preselected deposition rate of evaporated material has been achieved and measured, the substrate to be coated can be exposed to the evaporated material by moving a movable shutter from a blocking position to a non-blocking position. Accordingly, embodiments of the present disclosure have the advantage that the same set up can be used for adjusting a deposition rate prior to coating the substrate as well as for controlling the adjusted deposition rate during the coating process.

While the foregoing is directed to embodiments, other and further embodiments may be devised without departing from the basic scope, and the scope is determined by the claims that follow.

## Claims

1. A deposition apparatus (100) for depositing evaporated material onto a substrate (101), comprising:
- a deposition source (110) for providing evaporated material;
- a material deposition zone (111) provided between the deposition source (110) and the substrate (101);
- a deposition rate measurement device (130) provided in the material deposition zone (111); and
- a movable shutter (120) provided in the material deposition zone (111); wherein the movable shutter is configured to be moved in a first position (T1), a second position (T2) and a third position (T3),
wherein the first position (T1) is a position in which evaporated material is blocked from being deposited on the substrate (101) as well as blocked from being deposited on the deposition rate measurement device (130),
wherein the second position (T2) is a position in which evaporated material is blocked from being deposited on the substrate (101) and allowed to be deposited on the deposition rate measurement device (130), and
wherein the third position (T3) is a position in which evaporated material is allowed to be deposited on the substrate (101) as well as allowed to be deposited on the deposition rate measurement device (130).

2. The deposition apparatus (100) according to claim 1, wherein the deposition rate measurement device (130) is arranged in an edge region (111E) of the material deposition zone (111).

3. The deposition apparatus (100) according to claim 1 or 2, wherein the deposition rate measurement device (130) comprises an oscillation crystal (131) for measuring a deposition rate.

4. The deposition apparatus (100) according to claim 2, wherein the deposition rate measurement device (130) is arranged such that a detection surface (132) of the oscillation crystal (131) is oriented to be perpendicular to an evaporation direction of the deposition source.

5. The deposition apparatus (100) according to any of claims 1 to 3, wherein the movable shutter (120) comprises a thermal protection shield (121) and/or a thermal element (122).

6. The deposition apparatus (100) according to any of claims 1 to 4, wherein the substrate is a flexible substrate, and wherein the deposition apparatus further comprises at least one roll for transporting the flexible substrate.

7. A roll-to-roll deposition apparatus for depositing evaporated material onto a flexible substrate, comprising:
- a deposition source (110) for providing evaporated material, the deposition source (110) having an evaporation crucible being configured to evaporate the material to be deposited;
- a material deposition zone (111) provided between the deposition source (110) and the flexible substrate, the material deposition zone (111) having a conus-like shape with an opening angle α of 45° ≤ α ≤ 90° with respect to a main deposition direction (112) of the deposition source;
- a movable shutter (120) provided in the material deposition zone (111), wherein the movable shutter is configured to be moved in a first position (T1), a second position (T2) and a third position (T3), wherein the first position (T1) is a position in which evaporated material is blocked from being deposited on the substrate (101) as well as blocked from being deposited on the deposition rate measurement device (130), wherein the second position (T2) is a position in which evaporated material is blocked from being deposited on the substrate (101) and allowed to be deposited on the deposition rate measurement device (130), and wherein the third position (T3) is a position in which evaporated material is allowed to be deposited on the substrate (101) as well as allowed to be deposited on the deposition rate measurement device (130); and
- a deposition rate measurement device (130) provided in an edge region (111E) of the material deposition zone (111).

8. The roll-to-roll deposition apparatus according to claim 6, wherein the deposition rate measurement device (130) is provided between the deposition source (110) and the movable shutter (120), and the edge region (111E) being a region provided around the main deposition direction (112) from the opening angle α to a first angle α₁ with respect to the main deposition direction (112), the first angle α₁ being 0.5 × α ≤ α₁ ≤ α

9. A method (200) of preparing a deposition apparatus for depositing evaporated material on a substrate (101), the method comprising:
- evaporating a material to be deposited using a deposition source (110);
- preventing the evaporated material from being deposited onto the substrate (101) by employing a movable shutter (120) provided in a material deposition zone (111) provided between the deposition source (110) and the substrate (101); and
- measuring a deposition rate by a deposition rate measurement device (130) provided in the material deposition zone (111), particularly between the deposition source (110) and the movable shutter (120), wherein the movable shutter is configured to be moved in a first position (T1), a second position (T2) and a third position (T3), wherein the first position (T1) is a position in which evaporated material is blocked from being deposited on the substrate (101) as well as blocked from being deposited on the deposition rate measurement device (130), wherein the second position (T2) is a position in which evaporated material is blocked from being deposited on the substrate (101) and allowed to be deposited on the deposition rate measurement device (130), and wherein the third position (T3) is a position in which evaporated material is allowed to be deposited on the substrate (101) as well as allowed to be deposited on the deposition rate measurement device (130).

## Patentansprüche

1. Abscheidungseinrichtung (100) zum Abscheiden von verdampftem Material auf einem Substrat (101), umfassend:
- eine Abscheidungsquelle (110) zum Bereitstellen von verdampftem Material;
- eine Materialabscheidungszone (111), die zwischen der Abscheidungsquelle (110) und dem Substrat (101) bereitgestellt ist;
- eine Abscheidungsraten-Messvorrichtung (130), die in der Materialabscheidungszone (111) bereitgestellt ist; und
- einen beweglichen Verschluss (120), der in der Materialabscheidungszone (111) bereitgestellt ist; wobei der bewegliche Verschluss dafür konfiguriert ist, in eine erste Position (T1), eine zweite Position (T2) und eine dritte Position (T3) bewegt zu werden, wobei die erste Position (T1) eine Position ist, in der verdampftes Material daran gehindert wird, auf dem Substrat (101) abgeschieden zu werden, sowie daran gehindert wird, auf der Abscheidungsraten-Messvorrichtung (130) abgeschieden zu werden,
wobei die zweite Position (T2) eine Position ist, in der verdampftes Material daran gehindert wird, auf dem Substrat (101) abgeschieden zu werden, und ungehindert auf der Abscheidungsraten-Messvorrichtung (130) abgeschieden werden kann, und
wobei die dritte Position (T3) eine Position ist, in der verdampftes Material ungehindert auf dem Substrat (101) abgeschieden werden kann sowie ungehindert auf der Abscheidungsraten-Messvorrichtung (130) abgeschieden werden kann.

2. Abscheidungseinrichtung (100) nach Anspruch 1, wobei die Abscheidungsraten-Messvorrichtung (130) in einem Randbereich (111E) der Materialabscheidungszone (111) angeordnet ist.

3. Abscheidungseinrichtung (100) nach Anspruch 1 oder 2, wobei die Abscheidungsraten-Messvorrichtung (130) einen Schwingkristall (131) zum Messen einer Abscheidungsrate umfasst.

4. Abscheidungseinrichtung (100) nach Anspruch 2, wobei die Abscheidungsraten-Messvorrichtung (130) so angeordnet ist, dass eine Detektionsoberfläche (132) des Schwingkristalls (131) senkrecht zu einer Verdampfungsrichtung der Abscheidungsquelle ausgerichtet ist.

5. Abscheidungseinrichtung (100) nach einem der Ansprüche 1 bis 3, wobei der bewegliche Verschluss (120) einen Thermoschutzschild (121) und/oder ein Thermoelement (122) umfasst.

6. Abscheidungseinrichtung (100) nach einem der Ansprüche 1 bis 4, wobei das Substrat ein flexibles Substrat ist und wobei die Abscheidungseinrichtung ferner mindestens eine Walze zum Transportieren des flexiblen Substrats umfasst.

7. Rolle-zu-Rolle-Abscheidungseinrichtung zum Abscheiden von verdampftem Material auf einem flexiblem Substrat, umfassend:
- eine Abscheidungsquelle (110) zum Bereitstellen von verdampftem Material, wobei die Abscheidungsquelle (110) einen Verdampfungstiegel aufweist, der zum Verdampfen des abzuscheidenden Materials konfiguriert ist;
- eine Materialabscheidungszone (111), die zwischen der Abscheidungsquelle (110) und dem flexiblen Substrat bereitgestellt ist, wobei die Materialabscheidungszone (111) eine konusartige Form mit einem Öffnungswinkel α von 45° ≤ α ≤ 90° in Bezug auf eine Hauptabscheidungsrichtung (112) der Abscheidungsquelle aufweist;
- einen beweglichen Verschluss (120), der in der Materialabscheidungszone (111) bereitgestellt ist, wobei der bewegliche Verschluss so konfiguriert ist, dass er in eine erste Position (T1), eine zweite Position (T2) und eine dritte Position (T3) bewegt werden kann, wobei die erste Position (T1) eine Position ist, in der verdampftes Material daran gehindert wird, auf dem Substrat (101) abgeschieden zu werden, sowie daran gehindert wird, auf der Abscheidungsraten-Messvorrichtung (130) abgeschieden zu werden, wobei die zweite Position (T2) eine Position ist, in der verdampftes Material daran gehindert wird, auf dem Substrat (101) abgeschieden zu werden, und auf der Abscheidungsraten-Messvorrichtung (130) abgeschieden werden kann, und wobei die dritte Position (T3) eine Position ist, in der verdampftes Material auf dem Substrat (101) abgeschieden werden kann sowie auf der Abscheidungsraten-Messvorrichtung (130) abgeschieden werden kann; und
- eine Abscheidungsraten-Messvorrichtung (130), die in einem Randbereich (111E) der Materialabscheidungszone (111) bereitgestellt ist.

8. Rolle-zu-Rolle-Abscheidungseinrichtung nach Anspruch 6, wobei die Abscheidungsraten-Messvorrichtung (130) zwischen der Abscheidungsquelle (110) und dem beweglichen Verschluss (120) bereitgestellt ist und der Randbereich (111E) ein Bereich ist, der um die Hauptabscheidungsrichtung (112) herum vom Öffnungswinkel α bis zu einem ersten Winkel α₁ in Bezug zur Hauptabscheidungsrichtung (112) bereitgestellt ist, wobei der erste Winkel α₁ 0,5 x α ≤ α₁ ≤ α ist.

9. Verfahren (200) des Vorbereitens einer Abscheidungseinrichtung zum Abscheiden von verdampftem Material auf einem Substrat (101), wobei das Verfahren umfasst:
- Verdampfen eines abzuscheidenden Materials unter Verwendung einer Abscheidungsquelle (110);
- Verhindern, dass das verdampfte Material auf dem Substrat (101) abgeschieden wird, durch Verwenden eines beweglichen Verschlusses (120), der in einer Materialabscheidungszone (111) bereitgestellt ist, die zwischen der Abscheidungsquelle (110) und dem Substrat (101) bereitgestellt ist; und
- Messen einer Abscheidungsrate durch eine Abscheidungsraten-Messvorrichtung (130), die in der Materialabscheidungszone (111) bereitgestellt ist, insbesondere zwischen der Abscheidungsquelle (110) und dem beweglichen Verschluss (120), wobei der bewegliche Verschluss so konfiguriert ist, dass er in eine erste Position (T1), eine zweite Position (T2) und eine dritte Position (T3) bewegt werden kann, wobei die erste Position (T1) eine Position ist, in der verdampftes Material daran gehindert wird, auf dem Substrat (101) abgeschieden zu werden, sowie daran gehindert wird, auf der Abscheidungsraten-Messvorrichtung (130) abgeschieden zu werden, wobei die zweite Position (T2) eine Position ist, in der verdampftes Material daran gehindert wird, auf dem Substrat (101) abgeschieden zu werden, und auf der Abscheidungsraten-Messvorrichtung (130) abgeschieden werden kann, und wobei die dritte Position (T3) eine Position ist, in der verdampftes Material auf dem Substrat (101) abgeschieden werden kann sowie auf der Abscheidungsraten-Messvorrichtung (130) abgeschieden werden kann.

## Revendications

1. Appareil de dépôt (100) pour déposer du matériau évaporé sur un substrat (101), comprenant :
- une source de dépôt (110) pour fournir du matériau évaporé ;
- une zone de dépôt de matériau (111) fournie entre la source de dépôt (110) et le substrat (101) ;
- un dispositif de mesure de vitesse de dépôt (130) fourni dans la zone de dépôt de matériau (111) ; et
- un obturateur mobile (120) fourni dans la zone de dépôt de matériau (111) ; dans lequel l'obturateur mobile est configuré pour être déplacé dans une première position (T1), une deuxième position (T2) et une troisième position (T3), dans lequel la première position (T1) est une position dans laquelle du matériau évaporé est empêché par blocage de se déposer sur le substrat (101) ainsi qu'empêché par blocage de se déposer sur le dispositif de mesure de vitesse de dépôt (130),
dans lequel la deuxième position (T2) est une position dans laquelle du matériau évaporé est empêché par blocage de se déposer sur le substrat (101) et autorisé à se déposer sur le dispositif de mesure de vitesse de dépôt (130), et
dans lequel la troisième position (T3) est une position dans laquelle du matériau évaporé est autorisé à se déposer sur le substrat (101) ainsi qu'autorisé à se déposer sur le dispositif de mesure de vitesse de dépôt (130).

2. Appareil de dépôt (100) selon la revendication 1, dans lequel le dispositif de mesure de vitesse de dépôt (130) est agencé dans une région de bord (111E) de la zone de dépôt de matériau (111).

3. Appareil de dépôt (100) selon la revendication 1 ou 2, dans lequel le dispositif de mesure de vitesse de dépôt (130) comprend un cristal d'oscillateur (131) pour mesurer une vitesse de dépôt.

4. Appareil de dépôt (100) selon la revendication 2, dans lequel le dispositif de mesure de vitesse de dépôt (130) est agencé de sorte qu'une surface de détection (132) du cristal d'oscillateur (131) est orientée pour être perpendiculaire à une direction d'évaporation de la source de dépôt.

5. Appareil de dépôt (100) selon l'une quelconque des revendications 1 à 3, dans lequel l'obturateur mobile (120) comprend un bouclier de protection thermique (121) et/ou un élément thermique (122).

6. Appareil de dépôt (100) selon l'une quelconque des revendications 1 à 4, dans lequel le substrat est un substrat flexible, et dans lequel l'appareil de dépôt comprend en outre au moins un rouleau pour transporter le substrat flexible.

7. Appareil de dépôt de rouleau à rouleau pour déposer du matériau évaporé sur un substrat flexible, comprenant :
- une source de dépôt (110) pour fournir du matériau évaporé, la source de dépôt (110) ayant un creuset d'évaporation configuré pour évaporer le matériau à déposer ;
- une zone de dépôt de matériau (111) fournie entre la source de dépôt (110) et le substrat flexible, la zone de dépôt de matériau (111) ayant une forme de type cône avec un angle α d'ouverture de 45° ≤ α ≤ 90° par rapport à une direction principale de dépôt (112) de la source de dépôt ;
- un obturateur mobile (120) fourni dans la zone de dépôt de matériau (111), dans lequel l'obturateur mobile est configuré pour être déplacé dans une première position (T1), une deuxième position (T2) et une troisième position (T3), dans lequel la première position (T1) est une position dans laquelle du matériau évaporé est empêché par blocage de se déposer sur le substrat (101) ainsi qu'empêché par blocage de se déposer sur le dispositif de mesure de vitesse de dépôt (130), dans lequel la deuxième position (T2) est une position dans laquelle du matériau évaporé est empêché par blocage de se déposer sur le substrat (101) et autorisé à se déposer sur le dispositif de mesure de vitesse de dépôt (130), et dans lequel la troisième position (T3) est une position dans laquelle du matériau évaporé est autorisé à se déposer sur le substrat (101) ainsi qu'autorisé à se déposer sur le dispositif de mesure de vitesse de dépôt (130) ; et
- un dispositif de mesure de vitesse de dépôt (130) fourni dans une région de bord (111E) de la zone de dépôt de matériau (111).

8. Appareil de dépôt de rouleau à rouleau selon la revendication 6, dans lequel le dispositif de mesure de vitesse de dépôt (130) est fourni entre la source de dépôt (110) et l'obturateur mobile (120), et la région de bord (111E) étant une région fournie autour de la direction principale de dépôt (112) à partir de l'angle α d'ouverture jusqu'à un premier angle α₁ par rapport à la direction principale de dépôt (112), le premier angle α₁ étant 0,5 × α ≤ α₁ ≤ α

9. Procédé (200) de préparation d'un appareil de dépôt pour déposer du matériau évaporé sur un substrat (101), le procédé comprenant :
- l'évaporation de matériau à déposer en utilisant une source de dépôt (110) ;
- le fait d'empêcher du matériau évaporé de se déposer sur le substrat (101) en faisant appel à un obturateur mobile (120) fourni dans une zone de dépôt de matériau (111) fournie entre la source de dépôt (110) et le substrat (101) ; et
- la mesure d'une vitesse de dépôt par un dispositif de mesure de vitesse de dépôt (130) fourni dans la zone de dépôt de matériau (111), en particulier entre la source de dépôt (110) et l'obturateur mobile (120), dans lequel l'obturateur mobile est configuré pour être déplacé dans une première position (T1), une deuxième position (T2) et une troisième position (T3), dans lequel la première position (T1) est une position dans laquelle du matériau évaporé est empêché par blocage de se déposer sur le substrat (101) ainsi qu'empêché par blocage de se déposer sur le dispositif de mesure de vitesse de dépôt (130), dans lequel la deuxième position (T2) est une position dans laquelle du matériau évaporé est empêché par blocage de se déposer sur le substrat (101) et autorisé à se déposer sur le dispositif de mesure de vitesse de dépôt (130), et dans lequel la troisième position (T3) est une position dans laquelle du matériau évaporé est autorisé à se déposer sur le substrat (101) ainsi qu'autorisé à se déposer sur le dispositif de mesure de vitesse de dépôt (130).
